# EUROPEAN PATENT APPLICATION

(11) **EP 4 598 323 A1**
(43) Date of publication of application: **06.08.2025**
(21) Application number: 24204700.9
(22) Date of filing: 04.10.2024
(51) Int. Cl.: H10K 59/40, H10K 59/80, H10K 77/10

(54) **LIGHT EMITTING DISPLAY APPARATUS**

(30) Priority: 31.01.2024 KR 20240014934
(71) Applicant: LG Display Co., Ltd., Seoul 07336 (KR)
(72) Inventor: KANG, Munchan, 10845 Paju-si, Gyeonggi-do (KR); LEE, DongKyu, 10845 Paju-si, Gyeonggi-do (KR); JEON, JuWon, 10845 Paju-si, Gyeonggi-do (KR); KIM, Jaeho, 10845 Paju-si, Gyeonggi-do (KR); YUN, Jaeheon, 10845 Paju-si, Gyeonggi-do (KR)
(74) Representative: Viering, Jentschura & Partner mbB Patent- und Rechtsanwälte

(57) **Abstract**

An aspect of the present disclosure is directed to providing a light emitting display apparatus in which at least one organic layer covering a metal line (ML) provided in a bending area (BA) is over-etched. The light emitting display apparatus includes a flexible substrate (101); a pixel driving circuit layer (PDCL); a first planarization layer (106a); a second planarization layer (106b); a first non-display planarization layer (106c); a metal line (ML); a second non-display planarization layer (106d); and a non-display bank (NBK), wherein the non-display area (NDA) includes a bending area (BA) to be bent, a connection non-display area (CNDA) provided on one side of the bending area (BA) and connected to the display area (DA), and a pad non-display area (PNDA) provided on the other side of the bending area (BA), and a thickness (A) of the non-display bank (NBK) provided in the bending area (BA) is smaller than a thickness (B, C) of the non-display bank (NBK) provided in the connection non-display area (CNDA) and the pad non-display area (PNDA). Accordingly, TMAH and TMA ions do not remain in the bending area (BA), and thus defects in which cracks occur in the metal line (ML) can be reduced.

## Description

### CROSS-REFERENCE TO RELATED APPLICATIONS

This application claims priority to Korean Patent Application No. 10-2024-0014934 filed in the Republic of Korea, on January 31, 2024.

### BACKGROUND

### Field of Technology

The present disclosure relates to a light emitting display apparatus.

### Discussion of the Related Art

Light emitting display apparatuses are mounted on or provided in electronic products such as televisions, monitors, notebook computers, smart phones, tablet computers, electronic pads, wearable devices, watch phones, portable information devices, navigation devices, or vehicle control display devices, etc., to display images.

A light emitting display panel applied to a light emitting display apparatus can be manufactured using a flexible substrate. In this case, a crack may occur in a metal line provided in a bending area of the flexible substrate, and thus quality of the light emitting display apparatus may be deteriorated.

The above-described background is part of the present disclosure to devise the present disclosure or is technical information acquired by a process of devising the present disclosure, but cannot be regarded as the known art disclosed to the general public before the present disclosure is disclosed.

### SUMMARY

Accordingly, the present disclosure is directed to providing a light emitting display apparatus that substantially obviates one or more problems due to limitations and disadvantages of the related art.

An aspect of the present disclosure is directed to providing a light emitting display apparatus in which at least one organic layer covering a metal line provided in a bending area is over-etched.

Additional advantages and features of the disclosure will be set forth in part in the description which follows and in part will become apparent to those having ordinary skill in the art upon examination of the following or can be learned from practice of the disclosure. The objectives and other advantages of the disclosure can be realized and attained by the structure particularly pointed out in the written description as well as the appended drawings.

To achieve these and other advantages and in accordance with the purpose of the disclosure, as embodied and broadly described herein, there is provided a light emitting display apparatus according to claim 1. Further embodiments are described in the dependent claims. According to an aspect of the present disclosure, there is provided a light emitting display apparatus comprising a flexible substrate divided into a display area and a non-display area surrounding the display area; a pixel driving circuit layer provided in the display area and provided with pixel driving circuits; a first planarization layer covering the pixel driving circuit layer in the display area; a second planarization layer covering the first planarization layer; a first non-display planarization layer provided in the non-display area; a metal line provided on the first non-display planarization layer; a second non-display planarization layer covering the first non-display planarization layer and the metal line; and a non-display bank provided on the second non-display planarization layer, wherein the non-display area includes a bending area to be bent, a connection non-display area provided on one side of the bending area and connected to the display area, and a pad non-display area provided on the other side of the bending area, and a thickness of the non-display bank provided in the bending area is smaller than a thickness of the non-display bank provided in the connection non-display area and the pad non-display area. In addition, there is also provided a light emitting display apparatus comprising a flexible substrate divided into a display area and a non-display area surrounding the display area; a first non-display planarization layer provided in the non-display area; a metal line provided on the first non-display planarization layer; an organic material layer provided on the metal line, wherein the non-display area includes a bending area to be bent, a connection non-display area provided on one side of the bending area and connected to the display area, and a pad non-display area provided on the other side of the bending area, and a thickness of the organic material layer provided in the bending area is smaller than a thickness of the organic material layer provided in the connection non-display area and the pad non-display area.

It is to be understood that both the foregoing general description and the following detailed description of the present disclosure are example and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is an exemplary diagram illustrating a configuration of a light emitting display apparatus according to an embodiment of the present disclosure;
FIG. 2 is an exemplary diagram illustrating a structure of a pixel applied to a light emitting display apparatus according to an embodiment of the present disclosure;
FIG. 3 is an exemplary diagram illustrating a structure of a control driver applied to a light emitting display apparatus according to an embodiment of the present disclosure;
FIG. 4 is an exemplary diagram illustrating a structure of a gate driver applied to a light emitting display apparatus according to an embodiment of the present disclosure;
FIG. 5 is an exemplary diagram illustrating a structure of a data driver applied to a light emitting display apparatus according to an embodiment of the present disclosure;
FIG. 6 is an exemplary diagram illustrating a cross-sectional surface of a light emitting display panel applied to a light emitting display apparatus according to an embodiment of the present disclosure;
FIG. 7 is an exemplary diagram illustrating a state in which a bending area of a light emitting display panel illustrated in FIG. 6 is bent;
FIG. 8 is another exemplary diagram illustrating a cross-sectional surface of a light emitting display panel applied to a light emitting display apparatus according to an embodiment of the present disclosure;
FIG. 9 is an exemplary diagram illustrating a bending area applied to a light emitting display apparatus according to an embodiment of the present disclosure;
FIG. 10 is another exemplary diagram illustrating a bending area illustrated in FIG. 9;
FIG. 11 is another exemplary diagram illustrating a bending area applied to a light emitting display apparatus according to an embodiment of the present disclosure; and
FIG. 12 is another exemplary diagram illustrating a bending area applied to a light emitting display apparatus according to an embodiment of the present disclosure.

### DETAILED DESCRIPTION

Reference will now be made in detail to the exemplary embodiments of the present disclosure, examples of which are illustrated in the accompanying drawings. Wherever possible, the same reference numbers will be used throughout the drawings to refer to the same or like parts.

Advantages and features of the present disclosure, and implementation methods thereof will be clarified through following embodiments described with reference to the accompanying drawings. The present disclosure can, however, be embodied in different forms and should not be construed as limited to the embodiments set forth herein. Rather, these embodiments are provided so that this disclosure will be thorough and complete, and will fully convey the scope of the present disclosure to those skilled in the art.

A shape, a size, a ratio, an angle, and a number disclosed in the drawings for describing embodiments of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted. When "comprise," "have," and "include" described in the present disclosure are used, another part can be added unless "only" is used. The terms of a singular form can include plural forms unless referred to the contrary.

In construing an element, the element is construed as including an error or tolerance range although there is no explicit description of such an error or tolerance range.

In describing a position relationship, for example, when a position relation between two parts is described as, for example, "on," "over," "under," and "next," one or more other parts can be disposed between the two parts unless a more limiting term, such as "just" or "direct(ly)" is used.

In describing a time relationship, for example, when the temporal order is described as, for example, "after," "subsequent," "next," and "before," a case that is not continuous can be included unless a more limiting term, such as "just," "immediate(ly)," or "direct(ly)" is used.

It will be understood that, although the terms "first," "second," etc. can be used herein to describe various elements, these elements should not be limited by these terms. These terms are only used to distinguish one element from another and may not define order of sequence. For example, a first element could be termed a second element, and, similarly, a second element could be termed a first element, without departing from the scope of the present disclosure.

In describing elements of the present disclosure, the terms "first," "second," "A," "B," "(a)," "(b)," etc. can be used. These terms are intended to identify the corresponding elements from the other elements, and basis, order, or number of the corresponding elements should not be limited by these terms. As for the expression that an element is "connected," "coupled," or "adhered" to another element or layer, the element or layer can not only be directly connected or adhered to another element or layer, but also be indirectly connected or adhered to another element or layer with one or more intervening elements or layers "disposed," or "interposed" between the elements or layers, unless otherwise specified.

The term "at least one" should be understood as including any and all combinations of one or more of the associated listed items. For example, the meaning of "at least one of a first item, a second item, and a third item" denotes the combination of all items proposed from two or more of the first item, the second item, and the third item as well as the first item, the second item, or the third item. Also, the term "can" used herein includes all meanings and definitions of the word "may."

Features of various embodiments of the present disclosure can be partially or overall coupled to or combined with each other, and can be variously inter-operated with each other and driven technically as those skilled in the art can sufficiently understand. The embodiments of the present disclosure can be carried out independently from each other, or can be carried out together in co-dependent relationship.

Hereinafter, embodiments of the present disclosure will be described in detail with reference to the accompanying drawings.

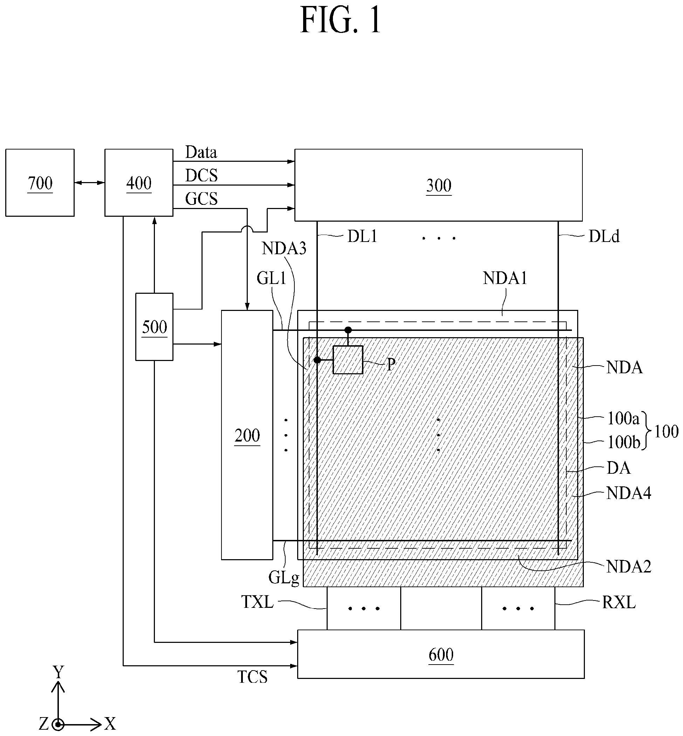

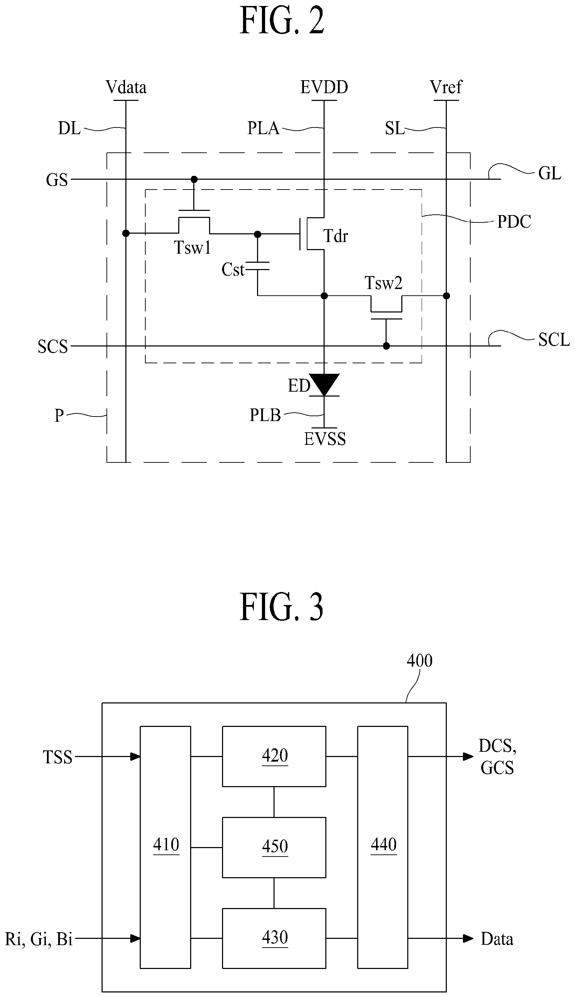

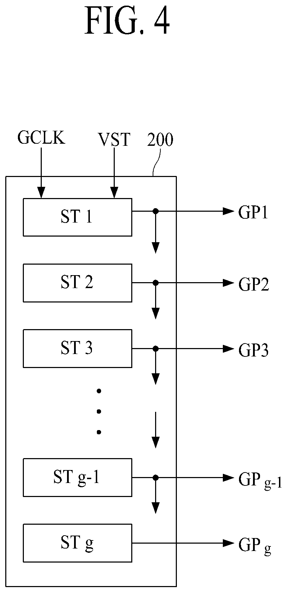

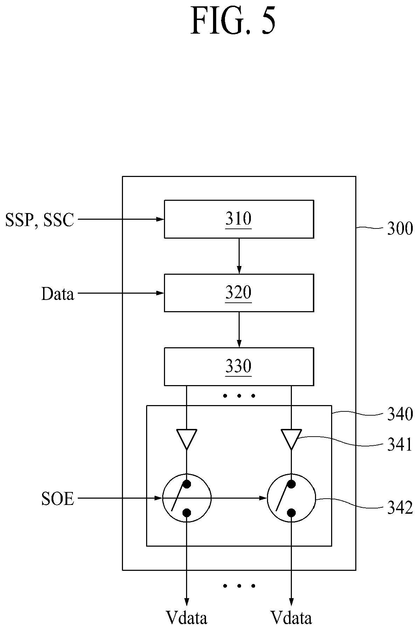

FIG. 1 is an exemplary diagram illustrating a configuration of a light emitting display apparatus according to an embodiment of the present disclosure, FIG. 2 is an exemplary diagram illustrating a structure of a pixel applied to a light emitting display apparatus according to an embodiment of the present disclosure, FIG. 3 is an exemplary diagram illustrating a structure of a control driver applied to a light emitting display apparatus according to an embodiment of the present disclosure, FIG. 4 is an exemplary diagram illustrating a structure of a gate driver applied to a light emitting display apparatus according to an embodiment of the present disclosure, and FIG. 5 is an exemplary diagram illustrating a structure of a data driver applied to a light emitting display apparatus according to an embodiment of the present disclosure.

A light emitting display apparatus according to an embodiment of the present disclosure can be used as various kinds of electronic devices. Electronic devices can be, for example, televisions, monitors, etc.

The light emitting display apparatus according to an embodiment of the present disclosure, as illustrated in FIG. 1, can include a light emitting display panel 100 which includes a display area DA displaying an image and a non-display area NDA provided outside the display area DA, a gate driver 200 which supplies gate signals GS to a plurality of gate lines GL1 to GLg provided in the display area DA of the light emitting display panel 100, a data driver 300 which supplies data voltages Vdata to a plurality of data lines DL1 to DLd provided in the display area DA of the light emitting display panel 100, a touch driver 600 which supplies a touch driving signal to a touch electrode provided in the light emitting display panel 100, a control driver 400 which controls driving of the gate driver 200, the data driver 300, and a touch driver 600, and a power supply unit 500 which supplies power to the control driver 400, the gate driver 200, the data driver 300, the touch driver 600, and the light emitting display panel 100.

First, the light emitting display panel 100 includes a light emitting device unit 100a on which an image is displayed and a touch electrode unit 100b in which a touch electrode for sensing a touch is provided.

The light emitting device unit 100a can include a display area DA and a non-display area NDA. Gate lines GL1 to GLg, data lines DL1 to DLd, and pixels P can be provided in the display area DA. Accordingly, an image can be displayed in the display area DA. Here, g and d are natural numbers. The non-display area NDA can surround the outer periphery of the display area DA.

The pixel P included in the light emitting device unit 100a, as illustrated in FIG. 2, can include a pixel driving circuit PDC which includes a switching transistor Tsw1, a storage capacitor Cst, a driving transistor Tdr, and a sensing transistor Tsw2, and a light emitting device ED connected to the pixel driving circuit PDC.

A first terminal of the driving transistor Tdr can be connected to a first voltage supply line through which a first voltage EVDD is supplied, and a second terminal of the driving transistor Tdr can be connected to the light emitting device ED.

A first terminal of the switching transistor Tsw1 can be connected to a data line DL, a second terminal of the switching transistor Tsw1 can be connected to a gate of the driving transistor Tdr, and a gate of the switching transistor Tsw1 can be connected to a gate line GL.

A data voltage Vdata can be supplied through the data line DL from the data driver 300. A gate signal GS can be supplied through the gate line GL from the gate driver 200. The gate signal GS can include a gate pulse GP for turning on the switching transistor Tsw1 and a gate-off signal for turning off the switching transistor Tsw1.

The sensing transistor Tsw2 can be provided for measuring a threshold voltage of the driving transistor Tdr or mobility of an electrical charge (for example, an electron), or supplying a reference voltage Vref to the pixel driving circuit PDC. A first terminal of the sensing transistor Tsw2 can be connected to the second terminal of the driving transistor Tdr and the light emitting device ED, a second terminal of the sensing transistor Tsw2 can be connected to a sensing line SL through which the reference voltage Vref is supplied, and a gate of the sensing transistor Tsw2 can be connected to a sensing control line SCL through which a sensing control signal SCS is supplied.

The sensing line SL can be connected to the data driver 300 and can be connected to the power supply unit 500 through the data driver 300. For example, the reference voltage Vref supplied from the power supply unit 500 can be supplied to the pixels through the sensing line SL, sensing signals transmitted from the pixels P can be converted into digital sensing signals in the data driver 300, and the digital sensing signals can be transmitted to the control driver 400.

The light emitting device ED can include a first electrode supplied with a first voltage EVDD through the driving transistor Tdr, a second electrode connected to a second voltage supply line PLB through which a second voltage is supplied, and a light emitting layer provided between the first electrode and the second electrode. The first electrode can be an anode and the second electrode can be a cathode.

The structure of the pixel P applied to a light emitting display apparatus according to an embodiment of the present disclosure is not limited to the structure illustrated in FIG. 2. Accordingly, the structure of the pixel P can be changed to various shapes.

The touch electrode unit 100b can perform a function of sensing a touch, and for this purpose, can include a touch electrode.

For example, when the touch electrode unit 100b uses a mutual-cap method, the touch electrode can include at least one touch driving electrode and at least one touch receiving electrode. In this case, the touch driver 600 can supply a touch driving signal to the touch driving electrode and can determine whether there is a touch by using a touch sensing signal received from the touch receiving electrode by the touch driving signal.

Moreover, when the touch electrode unit 100b detects a touch by an electronic pen, the touch driver 600 can supply an uplink signal to the touch driving electrode and determine whether there is a touch by using a downlink signal received from the electronic pen through the touch receiving electrode. In this case, the uplink signal can be the touch driving signal.

Also, when the touch electrode unit 100b uses a self-cap method, at least one touch electrode can be provided in the touch electrode unit 100b. In this case, the touch driver 600 can supply a touch driving signal to the touch electrode and can determine whether there is a touch by using a touch sensing signal received from the touch electrode.

Hereinafter, for convenience of description, a light emitting display apparatus including a touch electrode unit 100b using the mutual-cap method will be described as an example of a light emitting display apparatus according to an embodiment of the present disclosure.

In this case, as illustrated in FIG. 1, a touch driving electrode provided in the touch electrode unit 100b can be connected to the touch driver 600 through a touch driving electrode line TXL, and a touch receiving electrode provided in the touch electrode unit 100b can be connected to the touch driver 600 through a touch receiving electrode line RXL.

The control driver 400 can realign input image data Ri, Gi, and Bi transmitted from an external system 700 by using a timing synchronization signal TSS transmitted from the external system 700 and can generate a data control signal DCS which is to be supplied to the data driver 300 and a gate control signal GCS which is to be supplied to the gate driver 200.

To this end, as illustrated in FIG. 3, the control driver 400 can include a data aligner 430 which realigns input image data Ri, Gi, and Bi to generate image data Data, a control signal generator 420 which generates the gate control signal GCS and the data control signal DCS by using the timing synchronization signal TSS, an input unit 410 which transmits the timing synchronization signal TSS transmitted from the external system 700 to the control signal generator 420 and transmits the input image data Ri, Gi, and Bi transmitted from the external system 700 to the data aligner 430, and an output unit 440 which supplies the data driver 300 with the image data Data generated by the data aligner 430 and the data control signal DCS generated by the control signal generator 420 and supplies the gate driver 200 with the gate control signal GCS generated by the control signal generator 420.

The control signal generator 420 can generate a power control signal supplied to the power supply unit 500.

The control signal generator 420 can generate a touch control signal TCS supplied to the touch driver 600.

The control driver 400 can further include a storage unit 450 for storing various information. The storage unit 450 can be included in the control driver 400 as illustrated in FIG. 3, but can be separated from the control driver 400 and provided independently.

The external system 700 can perform a function of driving the control driver 400 and an electronic device.

For example, when the electronic device is a television (TV), the external system 700 can receive various kinds of sound information and image information over a communication network and can transmit the received image information to the control driver 400. For example, the external system 700 can convert the image information into input image data Ri, Gi, and Bi and transmit the input image data Ri, Gi, and Bi to the control driver 400.

The power supply unit 500 can generate various powers and supply the generated powers to the control driver 400, the gate driver 200, the data driver 300, and the touch driver 600.

The gate driver 200 can be directly embedded into the non-display area NDA by using a gate-in panel (GIP) type, or the gate driver 200 can be provided in the display area DA in which light emitting devices ED are provided, or the gate driver 200 can be provided on a chip on film mounted in the non-display area NDA.

The gate driver 200 can supply gate pulses GP1 to GPg to the gate lines GL1 to GLg.

When a gate pulse GP generated by the gate driver 200 is supplied to a gate of the switching transistor Tsw1 included in the pixel P, the switching transistor Tsw1 can be turned on. When the switching transistor Tsw1 is turned on, data voltage Vdata supplied through a data line DL can be supplied to the pixel P.

When a gate-off signal generated by the gate driver 200 is supplied to the switching transistor Tsw1, the switching transistor Tsw1 can be turned off. When the switching transistor Tsw1 is turned off, a data voltage cannot be supplied to the pixel P any longer.

The gate signal GS supplied to the gate line GL can include the gate pulse GP and the gate-off signal.

To supply gate pulses GP1 to GPg to gate lines GL1 to GLg, the gate driver 200, as illustrated in FIG. 4, can include stages ST1 to STg connected to gate lines GL1 to GLg.

Each of the stages ST1 to STg can be connected to one gate line GL, but can be connected to at least two gate lines GL.

In order to generate gate pulses GP1 to GPg, a gate start signal VST and at least one gate clock GCLK which are generated by the control signal generator 420 can be transferred to the gate driver 200. For example, the gate start signal VST and the at least one gate clock GCLK can be included in the gate control signal GCS.

One of the stages ST1 to STg can be driven by a gate start signal VST to output a gate pulse GP to a gate line GL. The gate pulse GP can be generated by a gate clock GCLK.

At least one of signals output from a stage ST where a gate pulse is output can be supplied to another stage ST to drive another stage ST. Accordingly, a gate pulse can be output in another stage ST.

For example, the stages ST can be driven sequentially to sequentially supply the gate pulses GP to the gate lines GL.

The data driver 300 can supply data voltages Vdata to the data lines DL1 to DLd.

To this end, the data driver 300, as illustrated in FIG. 5, can include a shift register 310 which outputs a sampling signal, a latch 320 which latches image data Data received from the control driver 400, a digital-to-analog converter 330 which converts the image data Data, transmitted from the latch 320, into a data voltage Vdata and outputs the data voltage Vdata, and an output buffer 340 which outputs the data voltage, transmitted from the digital-to-analog converter 330, to the data line DL on the basis of a source output enable signal SOE.

The shift register 310 can output the sampling signal by using the data control signal DCS received from the control signal generator 420. For example, the data control signals DCS transmitted to the shift register 310 can include a source start pulse SSP and a source shift clock signal SSC.

The latch 320 can latch image data Data sequentially received from the control driver 400, and then output the image data Data to the digital-to-analog converter 330 at the same time on the basis of the sampling signal.

The digital-to-analog converter 330 can convert the image data Data transmitted from the latch 320 into data voltages Vdata and output the data voltages Vdata.

The output buffer 340 can simultaneously output the data voltages Vdata transmitted from the digital-to-analog converter 330 to data lines DL1 to DLd of the light emitting display panel 100 on the basis of the source output enable signal SOE transmitted from the control signal generator 420.

To this end, the output buffer 340 can include a buffer 341 which stores the data voltage Vdata transmitted from the digital-to-analog converter 330 and a switch 342 which outputs the data voltage Vdata stored in the buffer 341 to the data line DL on the basis of the source output enable signal SOE.

For example, when the switches 342 are turned on based on the source output enable signal SOE simultaneously supplied to the switches 342, the data voltages Vdata stored in the buffers 341 can be supplied to the data lines DL1 to DLd through the switches 342.

The data voltages Vdata supplied to the data lines DL1 to DLd can be supplied to pixels P connected to a gate line GL supplied with a gate pulse GP.

Finally, the touch driver 600 can supply a touch driving signal to the touch electrode unit 100b, and can determine whether there is a touch by using a touch sensing signal received from the touch electrode unit 100b.

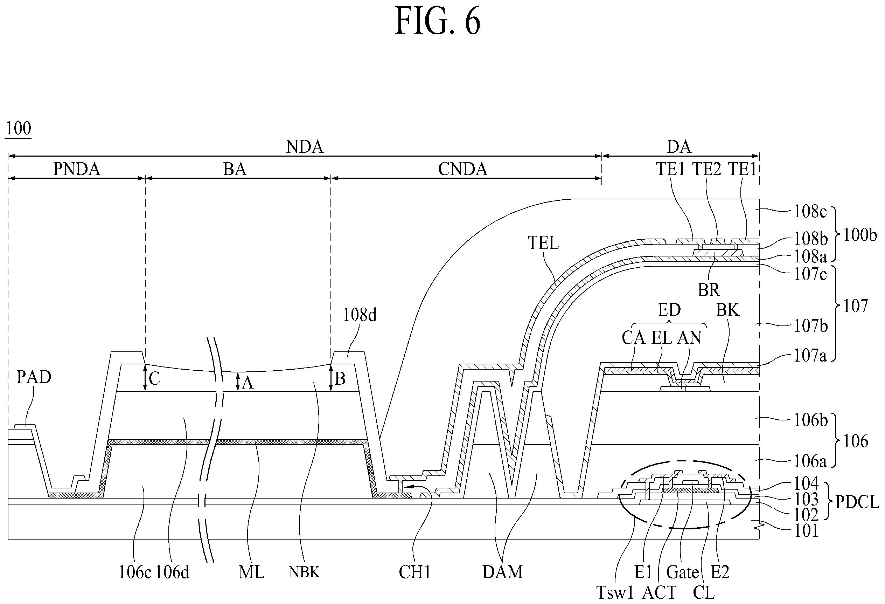

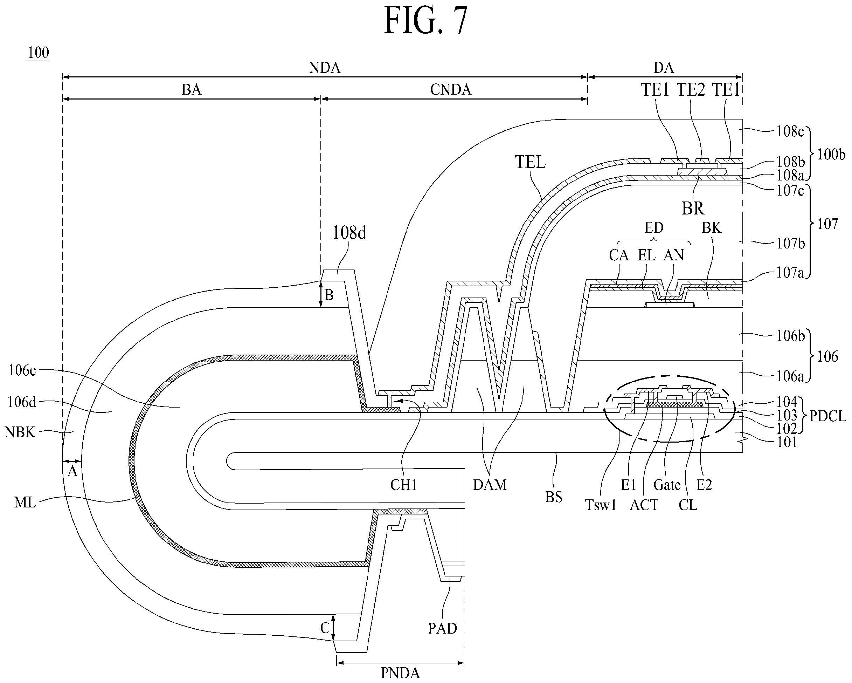

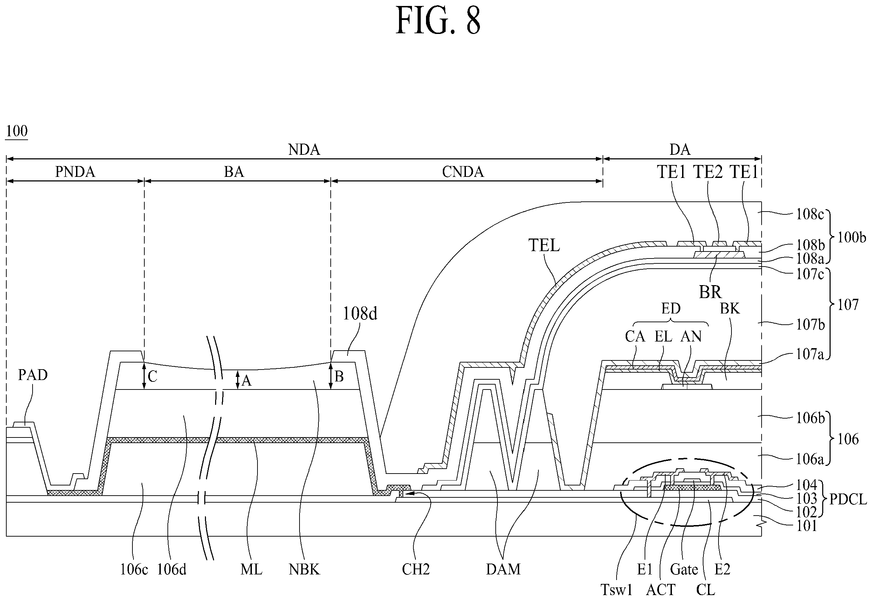

FIG. 6 is an exemplary diagram illustrating a cross-sectional surface of a light emitting display panel applied to a light emitting display apparatus according to an embodiment of the present disclosure, FIG. 7 is an exemplary diagram illustrating a state in which a bending area of a light emitting display panel illustrated in FIG. 6 is bent, and FIG. 8 is another exemplary diagram illustrating a cross-sectional surface of a light emitting display panel applied to a light emitting display apparatus according to an embodiment of the present disclosure. Particularly, a non-display area NDA of a light emitting display panel and a display area DA adjacent to the non-display area NDA are illustrated in FIGS. 6 to 8. In the following descriptions, details that are the same as or similar to details described with reference to FIGS. 1 to 5 will be omitted or briefly described.

As illustrated in FIGS. 6 to 8, a light emitting display panel 100 applied to a light emitting display apparatus according to an embodiment of the present disclosure can include a flexible substrate 101, a pixel driving circuit layer PDCL, a first planarization layer 106a, a second planarization layer 106b, a light emitting device ED, an encapsulation layer 107, a touch electrode unit 100b, a first non-display planarization layer 106c, a metal line ML, a second non-display planarization layer 106d, and a non-display bank NBK. In FIGS. 6 to 8, portions except for the touch electrode unit 100b are included in the light emitting device unit 100a illustrated in FIG. 1.

In this case, the pixel driving circuit layer PDCL, the first planarization layer 106a, the second planarization layer 106b, the light emitting device ED, the encapsulation layer 107, and the touch electrode unit 100b are provided in the display area DA in which an image is displayed, and the first non-display planarization layer 106c, the metal line ML, the second non-display planarization layer 106d, and the non-display bank NBK are provided in the non-display area NDA.

First, the flexible substrate 101 can be manufactured using various types of materials that can be bent, as illustrated in FIG. 7, and in particular, it can be manufactured using various types of materials applied to the current flexible panel.

For example, the flexible substrate 101 can be formed of any one of various types of plastic substrates or can be formed of a glass substrate.

For example, the flexible substrate 101 can be formed of an organic layer such as polyimide.

As illustrated in FIGS. 1 and 6, the flexible substrate 101 can include a display area DA in which an image is displayed and a non-display area NDA surrounding the display area.

The non-display area NDA can include a bending area BA to be bent, a connection non-display area CNDA provided on one side of the bending area BA and connected to the display area DA, and a pad non-display area PNDA provided on the other side of the bending area BA.

The bending area BA means an area that is bent as illustrated in FIG. 7.

The connection non-display area CNDA means an area provided between the bending area BA and the display area DA.

The pad non-display area PNDA means an area provided outside the bending area BA. The bending area BA is provided between the pad non-display area PNDA and the connection non-display area CNDA.

The bending area BA is connected to the connection non-display area CNDA, and can be bent in the direction of the lower surface BS of the substrate 101 together with the pad non-display area PNDA, as illustrated in FIG. 7.

Pads PAD connected to at least one of the gate driver 200, the data driver 300, the control driver 400, the power supply unit 500, and the touch driver 600 can be provided in the pad non-display area PNDA.

Accordingly, at least one of the gate driver 200, the data driver 300, the control driver 400, the power supply unit 500, and the touch driver 600 can be connected to the pad non-display area PNDA disposed adjacent to the lower surface BS of the flexible substrate 101 by the bending area BA.

For example, when the non-display area NDA includes a first non-display area NDA1, a second non-display area NDA2, a third non-display area NDA3, and a fourth non-display area NDA4, the bending area BA can be provided in at least one of the first to fourth non-display areas NDA1 to NDA4.

Only the connection non-display area CNDA can be provided in an area in which the bending area BA is not provided among the non-display areas NDA.

In this case, the gate driver 200 can be provided in the connection non-display area CNDA.

Next, the pixel driving circuit layer PDCL including pixel driving circuits PDC can be provided in the display area DA in the flexible substrate 101.

The pixel driving circuit layer PDCL can include the transistors Tswl, Tsw2, and Tdr and the capacitor Cst described with reference to FIG. 2.

That is, the transistors Tsw1, Tsw2, and Tdr and the capacitor Cst described with reference to FIG. 2 can be provided in the flexible substrate 101.

For example, a light emitting display panel 100 including only the switching transistor Tsw1 in the pixel driving circuit layer PDCL is illustrated in FIG. 6. However, various transistors and capacitors can be further provided in the pixel driving circuit layer PDCL in addition to the switching transistor Tsw1.

The pixel driving circuit layer PDCL can include at least one electrode layer and at least one insulation layer.

For example, when the switching transistor Tsw1 includes a first electrode E1, a second electrode E2, an active ACT, a gate insulation layer 103, and a gate Gate, as illustrated in FIG. 6, the pixel driving circuit layer PDCL can include two electrode layers and three insulation layers.

For example, the two electrode layers can include a first electrode layer including the first electrode E1 and a second electrode layer including the gate Gate.

Moreover, the three insulation layers can include a buffer 102, the gate insulation layer 103, and a gate passivation layer 104.

A connection line CL can be provided in the flexible substrate 101.

The connection line CL can be connected to any one of transistors and lines provided in the pixel driving circuit layer PDCL, and can be connected to any one of the gate driver 200, the data driver 300, the control driver 400, and the power supply unit 500 through a pad PAD.

Hereinafter, for convenience of description, a light emitting display apparatus according to an embodiment of the present disclosure will be described using a connection line CL connected to the first electrode E1 of the switching transistor Tsw1.

In this case, the connection line CL can be connected to the first terminal of the switching transistor Tsw1, and can be connected to the data driver 300 through a pad PAD.

For example, as described with reference to FIG. 2, the first electrode E1 of the switching transistor Tsw1 can be the first terminal connected to the data line DL, and the second electrode E2 of the switching transistor Tsw1 can be a second terminal connected to the gate of the driving transistor Tdr.

In this case, the first electrode E1 of the switching transistor Tsw1 can be connected to the connection line CL through a contact hole passing through the gate passivation layer 104, the gate insulation layer 103, and the buffer 102, as illustrated in FIG. 6. The connection line CL can extend to the pad non-display area PNDA and can be connected to a data pad, and the data pad can be connected to the data driver 300.

Light blocking plates in addition to the connection line CL can be further provided on the same layer as the connection line CL. Some of the light blocking plates can be connected to transistors included in the pixel driving circuit PDC, or can be connected to any one of the gate driver 200, the data driver 300, the control driver 400, the power supply unit 500, and the touch driver 600. That is, some of the light blocking plates can be connected to any one of the transistors, the gate driver 200, the data driver 300, the control driver 400, the power supply unit 500, and the touch driver 600.

Moreover, another part of the light blocking plates can perform a function of blocking light flowing into an active of a transistor. In this case, a light blocking layer can be provided independently without being connected to a transistor, the gate driver 200, the data driver 300, the control driver 400, the power supply unit 500, and the touch driver 600.

In this case, the connection line CL connected to the first electrode E1 of the switching transistor Tsw1 can further perform a function of a light blocking layer. That is, the connection line CL can perform a function of transmitting a voltage supplied from the data driver 300 to the switching transistor Tsw1, and can perform a function of blocking light flowing into the active ACT of the switching transistor Tsw1. Therefore, the connection line CL can perform a function of the data line.

The connection line CL can be covered by the buffer 102.

The buffer 102 can be formed of an organic material or an inorganic material, and can be formed of at least one organic material and at least one inorganic material.

The gate insulation layer 103 can also be formed of an organic material or an inorganic material, and can be formed of at least one organic material and at least one inorganic material.

The gate passivation layer 104 can also be formed of an organic material or an inorganic material, and can be formed of at least one organic material and at least one inorganic material.

Next, the gate passivation layer 104, the first electrode E1, and the second electrode E2 can be covered by the first planarization layer 106a.

The first planarization layer 106a can be covered by the second planarization layer 106b.

The first planarization layer 106a and the second planarization layer 106b perform a function of planarizing an upper surface of the pixel driving circuit layer PDCL.

The first planarization layer 106a and the second planarization layer 106b can be formed of various kinds of organic materials.

For example, the first planarization layer 106a and the second planarization layer 106b can be formed of a polyimide (PI) or acrylic polymer material, and can be formed using various organic materials used to manufacture light emitting display apparatus.

Each of the first planarization layer 106a and the second planarization layer 106b can be formed of at least one layer.

Next, an anode configuring the light emitting device ED can be provided on the second planarization layer 106b.

The anode AN can be formed of a transparent metal such as indium tin oxide (ITO), an opaque metal such as copper (Cu), or at least one transparent metal and at least one opaque metal.

The anode AN can be connected to the second terminal of the driving transistor Tdr.

The anode AN can be provided independently for each pixel P.

Next, a bank BK can be provided between the anodes AN.

The bank BK covers the outer edge of the anodes AN, and light can be output to the outside through an area (hereinafter simply referred to as an opening portion) of the anode AN that is not covered by the bank BK.

The bank BK can be formed of various kinds of organic materials.

For example, the bank BK can be formed of a polyimide (PI) or acrylic polymer material, and can be formed using various organic materials used to manufacture light emitting display apparatus.

Next, the anodes AN and the bank BK are covered by a light emitting layer EL.

The light emitting layer EL can be provided continuously between the anodes AN, or can be provided independently like the anode AN.

Next, the light emitting layer EL is covered by a cathode CA.

Next, the encapsulation layer 107 can be provided on the cathode CA to prevent moisture penetration.

The encapsulation layer 107 can prevent penetration of external moisture or oxygen into the light emitting device ED that is vulnerable to external moisture or oxygen. To this end, the encapsulation layer 107 can include at least one inorganic encapsulation layer and at least one organic encapsulation layer. However, a light emitting display apparatus according to an embodiment of the present disclosure is not limited thereto.

Hereinafter, an encapsulation layer including a first encapsulation layer 107a, a second encapsulation layer 107b, and a third encapsulation layer 107c will be described as an example of the encapsulation layer 107 applied to the light emitting display apparatus according to an embodiment of the present disclosure.

The first encapsulation layer 107a covers the cathode CA. The first encapsulation layer 107a can be formed of an inorganic material such as silicon nitride (SiNx), silicon oxide (SiOx), silicon oxynitride (SiON), or aluminum oxide (Al₂O₃).

The second encapsulation layer 107b can be formed of at least one of an acrylic resin, an epoxy resin, a phenolic resin, a polyamide resin, a polyimide resin, a polyethylene, a non-photosensitive organic material such as silicon oxycarbon (SiOC), and a photosensitive organic material such as a photo acrylic on the first encapsulation layer 107a, but is not limited thereto.

When the second encapsulation layer 107b is formed through an inkjet method, at least one dam DAM can be provided in the connection non-display area CNDA to prevent the second encapsulation layer 107b in a liquid form from being diffused to the outside of the flexible substrate 101. Due to the dam DAM, the second encapsulation layer 107b may not be diffused to the bending area BA.

In this case, the first encapsulation layer 107b can be formed from the display area DA to the dam DAM.

The dam DAM can be formed simultaneously with the first and second planarization layers 106a and 106b. For example, when the first planarization layer 106a is formed, a lower layer of the dam DAM can be formed, and when the second planarization layer 106b is formed, an upper layer of the dam DAM can be formed. Accordingly, the dam DAM can be formed in a double structure.

Therefore, the dam DAM can be formed of the same material as those of the first and second planarization layers 106a and 106b. However, the structure of the dam DAM applied to a light emitting display apparatus according to an embodiment of the present disclosure is not limited thereto.

The third encapsulation layer 107c is formed on the second encapsulation layer 107b, and can be formed to surround an upper surface, a lower surface, and a side surface of the second encapsulation layer 107b together with the first encapsulation layer 107a.

The first encapsulation layer 107a and the third encapsulation layer 107c can minimize or prevent external moisture or oxygen from penetrating into the light emitting device ED. The first encapsulation layer 107a and the third encapsulation layer 107c can be formed of an inorganic material capable of low-temperature deposition, such as silicon nitride (SiNx), silicon oxide (SiOx), silicon oxynitride (SiON), or aluminum oxide (Al₂O₃).

The light emitting device unit 100a includes the flexible substrate 101, the pixel driving circuit layer PDCL, the first planarization layer 106a, the second planarization layer 106b, the light emitting device ED, and the encapsulation layer 107.

Next, the touch electrode unit 100b can be provided on the encapsulation layer 107.

The touch electrode unit 100b includes a first touch insulation layer 108a provided on the encapsulation layer 107, a bridge electrode BR provided on the first touch insulation layer 108a, a second touch insulation layer 108b covering the bridge electrode BR, touch electrodes TE1 and TE2 provided on the second touch insulation layer, and a touch passivation layer 108c covering the second touch insulation layer 108b and the touch electrodes TE1 and TE2.

When the touch electrode unit 100b is configured in a mutual-cap manner, the touch electrodes TE1 and TE2 can include a touch driving electrode TE1 to which a touch driving signal is supplied and a touch receiving electrode TE2 from which a touch sensing signal is generated.

The touch driving electrode TE1 and the touch receiving electrode TE2 can be formed on the same layer, for example, on the second touch insulation layer 108b.

The touch driving electrode TE1 and the touch receiving electrode TE2 can extend in different directions. Accordingly, an area where the touch driving electrode TE1 and the touch receiving electrode TE2 overlap can occur.

In an area where the touch driving electrode TE1 and the touch receiving electrode TE2 overlap, any one of the touch driving electrode TE1 and the touch receiving electrode TE2 can be connected through the bridge electrode BR. The bridge electrode BR can be formed on a layer different from the touch driving electrode TE1 and the touch receiving electrode TE2, and for example, can be formed on the first touch insulation layer 108a.

Each of the touch driving electrode TE1 and the touch receiving electrode TE2 can be connected to the touch driver 600 through a touch electrode line TEL. To this end, the touch electrode line TEL can extend to the pad non-display area PNDA.

A touch electrode line TEL connected to the touch driving electrode TE1 can be the touch driving electrode line TXL described with reference to FIG. 1, and a touch electrode line TEL connected to the touch receiving electrode TE2 can be the touch receiving electrode line RXL described with reference to FIG. 1.

As illustrated in FIG. 6, the touch electrode line TEL can be provided on the second touch insulation layer 108b, but can also be provided on the first touch insulation layer 108a.

The touch driving electrode TE1, the touch receiving electrode TE2, and the touch electrode line TEL can be covered by the touch passivation layer 108c, as illustrated in FIG. 6.

The first touch insulation layer 108a, the second touch insulation layer 108b, and the touch passivation layer 108c can extend beyond the dam DAM to the connection non-display area CNDA.

The first touch insulation layer 108a and the second touch insulation layer 108b can be formed of an inorganic material, and the touch passivation layer 108c can be formed of an organic material.

For example, the first touch insulation layer 108a and the second touch insulation layer 108b can be formed of silicon oxide (SiOx), silicon nitride (SiNx), metal oxide, or metal nitride, or in addition to this, various inorganic materials used in manufacturing light emitting display apparatuses.

Moreover, the touch passivation layer 108c can be formed of a polyimide (PI) or acrylic polymer material, and can be formed using various organic materials used to manufacture light emitting display apparatuses.

Next, the first non-display planarization layer 106c is provided in the non-display area NDA. The first non-display planarization layer 106c can be provided on the buffer 102.

The first non-display planarization layer 106c can be formed of the same material as the first planarization layer 106a, and can be formed together with the first planarization layer 106a.

Therefore, the first non-display planarization layer 106c can be formed of an organic material.

The first non-display planarization layer 106c can be provided, in particular, in the bending area BA among the non-display area NDA, and can extend to a partial area of the pad non-display area PNDA and a partial area of the connection non-display area CNDA.

Next, the metal line ML can be provided on the first non-display planarization layer 106c.

The metal line ML can be connected to the touch electrode TE1 or TE2 provided on the pixel driving circuit layer PDCL or to a transistor provided in the pixel driving circuit layer PDCL.

For example, in a light emitting display panel illustrated in FIG. 6, the metal line ML is connected to the touch electrode TE1 or TE2 provided in the touch electrode unit 100b.

To this end, a first contact hole CH1 is provided in the second touch insulation layer 108b extending to the connection non-display area CNDA, and the touch electrode line TEL connected to the touch electrode TE1 or TE2 can be connected to the metal line ML through the first contact hole CH1 in the connection non-display area CNDA.

In this case, the metal line ML extends from the connection non-display area CNDA to the pad non-display area PNDA through the bending area BA, and is connected to the pad PAD in the pad non-display area PNDA. The pad PAD can be connected to the touch driver 600.

Therefore, the touch electrode line TEL can be connected to the touch driver 600.

Accordingly, the touch driving signal transmitted from the touch driver 600 can be transmitted to the touch driving electrode TE1 through the metal line ML and the touch electrode line TEL, or the touch sensing signal generated from the touch receiving electrode TE1 can be transmitted to the touch driver 600 through the touch electrode line TEL and the metal line ML.

Also, in a light emitting display panel illustrated in FIG. 8, the metal line ML is connected to a transistor provided in the pixel driving circuit layer PDCL, and in particular, connected to the first electrode E1 of the switching transistor Tsw1.

To this end, the connection line CL provided in the flexible substrate 101 is connected to the first electrode E1 of the switching transistor Tsw1 provided in the pixel driving circuit layer PDCL. Also, a second contact hole CH2 is provided in the connection non-display area CNDA, and the connection line CL extending to the connection non-display area CNDA can be connected to the metal line ML through the second contact hole CH2 in the connection non-display area CNDA.

In this case, the metal line ML extends from the connection non-display area CNDA to the pad non-display area PNDA through the bending area BA, and is connected to the pad PAD in the pad non-display area PNDA. The pad PAD can be connected to the data driver 300.

Therefore, the first electrode E1 of the switching transistor Tsw1 can be connected to the data driver 300.

Accordingly, a data voltage Vdata output from the data driver 300 can be supplied to the first electrode E1 of the switching transistor Tsw1 through the metal line ML and the connection line CL.

In this case, the connecting line CL can perform a function of the data line DL.

Next, the first non-display planarization layer 106c and the metal line ML can be covered by the second non-display planarization layer 106d.

The second non-display planarization layer 106d can be formed of the same material as the second planarization layer 106b, and can be formed together with the second planarization layer 106b.

Therefore, the second non-display planarization layer 106d can be formed of an organic material.

The second non-display planarization layer 106d can be provided, in particular, in the bending area BA in the non-display area NDA, and can extend to a partial area of the pad non-display area PNDA and a partial area of the connection non-display area CNDA.

Next, the second non-display planarization layer 106d can be covered by the non-display bank NBK.

The non-display bank NBK can be formed of the same material as the bank BK, and can be formed together with the bank BK.

Therefore, the non-display bank NBK can be formed of an organic material.

The non-display bank NBK can be provided in the bending area BA especially, among the non-display area NDA, and can extend to a partial area of the pad non-display area PNDA and a partial area of the connection non-display area CNDA.

In this case, as illustrated in FIG. 6, a thickness A of the non-display bank NBK provided in the bending area BA is smaller than a thickness B of the non-display bank provided in the connection non-display area CNDA and a thickness C of the non-display bank provided in the pad non-display area PNDA.

Accordingly, Tetramethyl Ammonium hydroxide (hereinafter simply referred to as TMAH) and TMA+ (hereinafter simply referred to as TMA ions) may not remain in the upper surface of the non-display bank NBK provided in the bending area BA.

Because TMAH and TMA ions do not remain in the bending area BA, defects in which cracks occur in the metal line ML can be reduced.

TMAH is a material used for patterning the first planarization layer 106a, the second planarization layer 106b, the first non-display planarization layer 106c, the second non-display planarization layer 106d, the bank BK, the non-display bank NBK, and the touch passivation layer 108c, or for patterning various electrodes and lines provided in the layers.

For example, TMAH is a material used in a development process of developing photoresists and organic films used for patterning the configurations described above.

For example, a solution containing TMAH is used in the development process for patterning various configurations provided on the light emitting display panel 100, and after the development process is performed, a strip process is performed to wash the solution containing TMAH.

However, even if the strip process is performed, the TMAH can remain on an upper surface of each of the first planarization layer 106a, the second planarization layer 106b, the first non-display planarization layer 106c, the second non-display planarization layer 106d, the bank BK, and the non-display bank NBK.

Also, when the TMAH meets with water or another solution and is ionized, TMA ions can be generated. That is, when a hydroxide group (-OH) is separated from the TMAH, TMA ions (TMA+) can be generated.

That is, even if the strip process is performed, TMAH or TMA ions can remain in the layers described above by chemically or physically combining with materials provided in the layers described above.

Therefore, if the development process and strip process are performed using a solution containing TMAH, at least one of the TMAH and TMA ions can remain on an upper surface of an organic material layer such as the first planarization layer 106a, the second planarization layer 106b, the first non-display planarization layer 106c, the second non-display planarization layer 106d, the bank BK, and the non-display bank NBK.

For example, TMAH can chemically or physically bond with other functional groups contained in the organic material layer, and thus, at least one of TMAH and TMA ions can remain in the organic material layer.

TMAH and TMA ions remaining in the organic material layer are the main causes of crack defects in the metal line ML provided in the bending area BA.

For example, the organic material layer provided on the metal line ML can be damaged by TMAH and TMA ions, and moisture penetrating from the outside through the damaged organic material layer can cause cracks in the metal line ML.

Particularly, in the bending area BA where the flexible substrate 101 is bent, TMAH and TMA ions are aggregated by bending stress, and cracks can occur in the metal line ML by the aggregated TMAH and TMA ions.

In other words, damage to the organic material layer by TMAH and TMA ions can occur severely in the bending area BA where bending stress is continuously applied, and thus, cracks can occur in the metal line ML provided in the bending area BA.

However, in a present disclosure, over-etching can be performed on the non-display bank NBK, which is an organic material layer. In the following description, over-etching means cutting a target further than an original target thickness by increasing the number or time of an etching process. That is, an additional etching process can be further performed for the over-etching, and the time of the etching process can be increased for the over-etching. For example, through a dry etching process, over-etching can be performed on the non-display bank NBK provided in the bending area BA.

To provide an additional description, after the non-display bank NBK and the bank BK are formed, an over-etching process can be performed on the non-display bank NBK in an etching process for forming at least one of the light emitting layer EL, the cathode CA, the first encapsulation layer 107a, the third encapsulation layer 107c, the first touch insulation layer 108a, the second touch insulation layer 108b, the touch electrodes TE1 and TE2, and the touch electrode line TEL provided on the bank BK.

TMAH and TMA ions remaining in the upper surface of the non-display bank NBK provided in the bending area BA can be removed together with the upper surface of the non-display bank NBK when the upper surface of the non-display bank NBK is removed by over-etching.

Accordingly, TMAH and TMA ions do not remain in an upper surface of the non-display bank NBK provided in the bending area BA.

Therefore, even if bending stress is continuously applied to the non-display bank NBK in the bending area BA, the non-display bank NBK in the bending area BA is not damaged by TMAH and TMA ions, and thus, cracks do not occur in the metal line ML provided at the lower end of the non-display bank NBK.

Therefore, even if a light emitting display apparatus is continuously used, defects in which cracks occur in the metal line ML can be reduced compared to the prior art or may not occur.

By the over-etching process as described above, the thickness A of the non-display bank NBK provided in the bending area BA can be smaller than the thickness B of the non-display bank NBK provided in the connection non-display area CNDA and the thickness C of the non-display bank NBK provided in the pad non-display area PNDA.

Finally, the metal line ML connected to the touch electrode TE1 or TE2 or a transistor provided in the pixel driving circuit layer PDCL can extend to the pad non-display area PNDA, as illustrated in FIGS. 6 and 8.

The metal line ML extending to the pad non-display area PNDA can be connected to the pad PAD.

Any one of the gate driver 200, the data driver 300, the control driver 400, the power supply unit 500, and the touch driver 600 can be connected to the pad PAD.

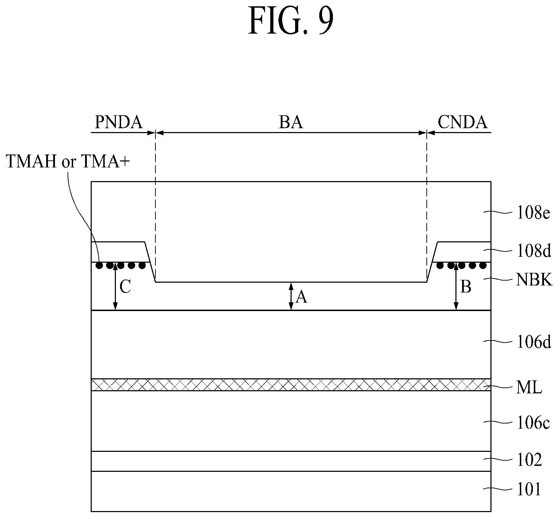

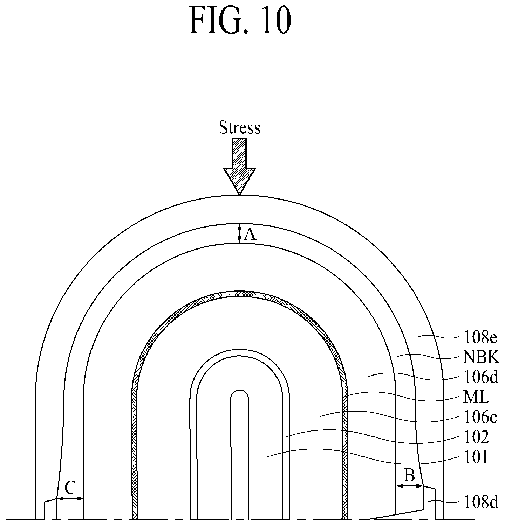

FIG. 9 is an exemplary diagram illustrating a bending area applied to a light emitting display apparatus according to an embodiment of the present disclosure, and FIG. 10 is another exemplary diagram illustrating a bending area illustrated in FIG. 9. In particular, the bending area BA that is not bent is illustrated in FIG. 9, and the bending area BA that is bent is illustrated in FIG. 10. In the following descriptions, details that are the same as or similar to details described with reference to FIGS. 1 to 8 will be omitted or briefly described.

As described above, the first non-display planarization layer 106c on the flexible substrate 101 or the buffer 102, the metal line ML on the first non-display planarization layer, the second non-display planarization layer 106c covering the first non-display planarization layer 106c and the metal line ML, and the non-display bank NBK on the second non-display planarization layer 106d can be provided in the bending area BA.

First, the non-display bank NBK can be formed of the same material as the bank BK, and can be patterned together with the bank BK.

After the non-display bank NBK and the bank BK are formed, a patterned light emitting layer EL or a patterned cathode CA can be provided on the bank BK. Also, after the non-display bank NBK and the bank BK are formed, the patterned first encapsulation layer 107a, the patterned second encapsulation layer 107b, the patterned first touch insulation layer 108a, the patterned second touch insulation layer 108b, the patterned bridge electrode BR, the patterned touch electrodes TE1 and TE2, and the patterned touch electrode line TEL can be formed on the bank BK.

In the following description, a patterned layer or line provided on the bank BK is simply referred to as a pattern layer.

The pattern layer can be formed through a development process of developing a photoresist and an etching process of etching various materials.

That is, after the non-display bank NBK and the bank BK are formed, in order to form various pattern layers, an etching process should be performed.

When the etching process for forming the pattern layer is performed, the etching process can also be performed on the non-display bank NBK provided in the bending area BA.

TMAH and TMA ions remaining in the upper surface of the non-display bank NBK provided in the bending area BA can be removed together with the upper surface of the non-display bank NBK when the upper surface of the non-display bank NBK is removed by an etching process on the non-display bank NBK.

For example, as illustrated in FIGS. 6 and 10, when an etching process is performed to form the non-display touch insulation layer 108d and the second touch insulation layer 108b, both ends of the non-display bank NBK can be covered by the non-display touch insulation layer 108d formed of the same material as the second touch insulation layer 108b.

That is, after a touch insulation layer material forming the second touch insulation layer 108b and the non-display touch insulation layer 108d is deposited on the entire surface of the flexible substrate 101, a contact hole for connecting the bridge electrode BR and the touch electrode TE1 or TE2 can be formed. To this end, an etching process can be performed. The second touch insulation layer 108b having the contact holes formed therein can be formed by the etching process, and the non-display touch insulation layer 108d exposing the non-display bank NBK can be formed. Also, when the etching process is performed, the upper surface of the non-display bank NBK can be removed by etching.

Also, the touch insulation layer material forming the second touch insulation layer 108b and the non-display touch insulation layer 108d is formed of an inorganic material, and the inorganic material provided in the bending area BA can be damaged by bending. Accordingly, an etching process can be performed to remove the touch insulation layer material provided in the bending area BA. By the etching process, the non-display touch insulation layer 108d can be formed only at both ends of the non-display bank NBK, and the non-display bank NBK provided in the bending area BA can be exposed. Moreover, the upper surface of the non-display bank NBK provided in the bending area BA can be removed by etching in the etching process to remove the touch insulation layer material.

Also, an etching process can be performed to form the touch electrodes TE1 and TE2 and the touch electrode lines TELs provided on the second touch insulation layer 108b. When the etching process is performed, the upper surface of the non-display bank NBK provided in the bending area BA can be removed by etching.

Therefore, the upper surface of the non-display bank NBK provided in the bending area BA can be removed by the etching process as described above.

Moreover, while the non-display bank NBK is exposed in the bending area BA, a process of etching the non-display bank NBK can be performed at least once more.

Accordingly, the thickness A of the non-display bank NBK provided in the bending area BA can be smaller than the thickness B of the non-display bank NBK provided in the connection non-display area CNDA and the thickness C of the non-display bank NBK provided in the pad non-display area PNDA.

Also, TMAH and TMA ions, which are used in the development process of developing photoresists to form the pattern layers and remain in the upper surface of the non-display bank NBK after the strip process, can be removed together with the upper surface of the non-display bank NBK when the upper surface of the non-display bank NBK is removed by the etching process as described above.

Therefore, TMAH and TMA ions do not remain in the upper surface of the non-display bank NBK provided in the bending area BA.

Accordingly, defects in which the metal line ML is damaged by TMAH and TMA ions can be prevented or reduced.

Also, before the non-display touch insulation layer 108d is formed on the non-display bank NBK, the entire upper surface of the non-display bank NBK can be removed by etching, and thus, TMAH and TMA ions do not remain in the upper surface of the non-display bank NBK remaining after etching.

In this case, the thickness of the non-display bank NBK can be less than the thickness of the bank BK. For example, the non-display bank NBK can be formed by using the same material as the bank BK and by using the same process as the bank BK, and after the non-display bank NBK and the bank BK are formed, an additional etching process can be performed only on the non-display bank NBK. Accordingly, the thickness of the non-display bank NBK can be less than the thickness of the bank BK.

Next, the metal line ML can be connected to the touch electrode TE1 or TE2 provided on the pixel driving circuit layer PDCL, or connected to a transistor or line provided in the pixel driving circuit layer PDCL.

For example, when the touch electrode unit 100b is provided on the encapsulation layer 107, the metal line ML can be connected to the touch electrode TE1 or TE2, and in particular, can be connected to the touch electrode line TEL connected to the touch electrode TE1 or TE2.

To this end, the first contact hole CH1 can be provided in the second touch insulation layer 108b extending to the connection non-display area CNDA, as illustrated in FIG. 6, and the touch electrode line TEL connected to the touch electrode TE1 or TE2 can be connected to the metal line ML through the first contact hole CH1.

The metal line ML can be connected to the touch driver 600 through a pad PAD provided in the pad non-display area PNDA.

As another example, when the connection line CL connected to a transistor or line provided in the pixel driving circuit layer PDCL is provided on the flexible substrate 101, the metal line ML can be connected to the connection line CL through the second contact hole CH2 formed in the buffer 102 covering the connection line CL, as illustrated in FIG. 8.

Here, the transistor provided in the pixel driving circuit layer PDCL can be any one of the switching transistor Tsw1, the sensing transistor Tsw2, and the driving transistor Tdr described with reference to FIG. 2, and in addition to these, can be any one of the transistors provided in the pixel driving circuit layer PDCL.

Moreover, the line provided in the pixel driving circuit layer PDCL can be any one of the data line DL, the gate line GL, the sensing line SL, the sensing control line SCL, the first voltage supply line PLA, and the second voltage supply line PLB described with reference to FIG. 2.

Next, the non-display bank NBK provided in the bending area BA can be covered by the non-display touch passivation layer 108e including the same material as the touch passivation layer 108c provided in the touch electrode unit 100b, as illustrated in FIG. 9.

For example, the upper surface of the non-display bank NBK provided in the bending area BA can, as illustrated in FIGS. 6 to 8, be open but can be covered by the non-display touch passivation layer 108e, as illustrated in FIG. 9.

The non-display touch passivation layer 108e can be formed of an organic material. Therefore, the non-display touch passivation layer 108e can block moisture introduced from the outside. Because moisture introduced into the non-display bank NBK can be blocked by the non-display touch passivation layer 108e, a size in which the non-display bank NBK is damaged by moisture can be reduced. Therefore, a size in which the metal line CL provided at the lower end of the non-display bank NBK is damaged can be reduced.

Next, in the connection non-display area CNDA and the pad non-display area PNDA, a non-display touch insulation layer 108d can be further provided, as illustrated in FIGS. 6 to 9.

The non-display touch insulation layer 108d can be formed of at least one layer.

For example, as illustrated in FIGS. 6 to 8, the non-display touch insulation layer 108d can be formed of the same material as the second touch insulation layer 108b, and can be formed through the same process as the second touch insulation layer 108b.

However, the non-display touch insulation layer 108d can further include a layer which is formed of the same material as the first touch insulation layer 108a and formed through the same process as the first touch insulation layer 108a.

That is, the non-display touch insulation layer 108d can include at least one of the same material as the first touch insulation layer 108a and the same material as the second touch insulation layer 108b.

In this case, the non-display touch insulation layer 108d may not be covered by the non-display touch passivation layer 108e, as illustrated in FIGS. 6 to 8.

However, the non-display touch insulation layer 108d can be covered by the non-display touch passivation layer 108e, as illustrated in FIG. 9.

For example, the non-display touch insulation layer 108d provided on the non-display bank NBK and covered by the non-display touch passivation layer 108e can be provided in the connection non-display area CNDA and the pad non-display area PNDA, as illustrated in FIG. 9.

That is, the non-display touch passivation layer 108e can cover the upper end of the non-display bank NBK and the upper end of the non-display touch insulation layer 108d.

In this case, the non-display touch insulation layer 108d can include at least one of the same material as the first touch insulation layer 108a and the same material as the second touch insulation layer 108b, as described above.

Next, the first non-display planarization layer 106c can include the same material as the first planarization layer 106a, and the second non-display planarization layer 106d can include the same material as the second planarization layer 106b.

That is, the first non-display planarization layer 106c can be simultaneously formed through the same process as the first planarization layer 106a, and the second non-display planarization layer 106d can be simultaneously formed through the same process as the second planarization layer 106b.

Finally, as illustrated in FIGS. 9 and 10, when the non-display bank NBK is covered by the non-display touch passivation layer 108e, the tensile stress applied to the bending area BA can be reduced by the non-display touch passivation layer 108e.

For example, the bending stress of the bending area BA can decrease as the total thickness of the bending area BA increases, and in particular, the tensile stress applied to a layer provided at the lower end in the bending area BA can decrease.

To use this principle, in a light emitting display apparatus according to an embodiment of the present disclosure, as illustrated in FIGS. 9 and 10, the upper end of the non-display bank NBK can be covered by the non-display touch passivation layer 108e.

That is, the entire thickness of the bending area BA can be increased by the non-display touch passivation layer 108e, and thus, stress applied to the layer provided at the lower end in the bending area BA can be reduced. This effect is called a neutral plane effect.

Therefore, defects in which the various layers 101, 102, 106a, 106b, and 108d and the metal line ML in the bending area BA are damaged can be prevented or reduced, and cracks in the various layers 101, 102, 106a, 106b, and 108d and the metal line ML in the bending area BA can be prevented or reduced.

Also, by forming at least one of the non-display touch passivation layer 108e, the first non-display planarization layer 106c, and the second non-display planarization layer 106d in multiple layers, the stress applied to the metal line ML can be further reduced, and thus, cracks in the metal line ML can be further prevented or further reduced.

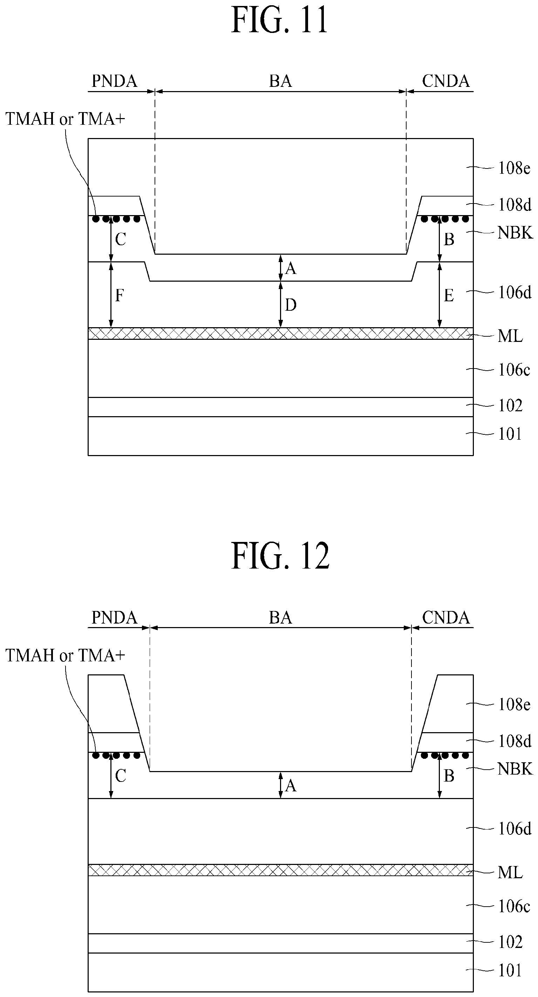

FIG. 11 is another exemplary diagram illustrating a bending area applied to a light emitting display apparatus according to an embodiment of the present disclosure. In the following descriptions, details that are the same as or similar to details described with reference to FIGS. 1 to 10 will be omitted or briefly described.

First, as described above, the bending area BA can include the first non-display planarization layer 106c provided on the flexible substrate 101 or the buffer 102, the metal line ML provided on the first non-display planarization layer, the second non-display planarization layer 106d covering the first non-display planarization layer 106c and the metal line ML, and the non-display bank NBK provided on the second non-display planarization layer 106d.

The thickness A of the non-display bank NBK provided in the bending area BA can be smaller than the thickness B of the non-display bank NBK provided in the connection non-display area CNDA and the thickness C of the non-display bank NBK provided in the pad non-display area PNDA.

In this case, there are no TMAH and TMA ions in the upper surface of the non-display bank NBK provided in the bending area BA, and there may be TMAH and TMA ions in the upper surface of the non-display bank NBK provided in the connection non-display area CNDA and the pad non-display area PNDA.

Also, as illustrated in FIG. 11, the thickness D of the second non-display planarization layer 106d provided in the bending area BA can be smaller than the thickness E of the second non-display planarization layer 106d provided in the connection non-display area CNDA and the thickness F of the second non-display planarization layer 106d provided in the pad non-display area PNDA.

For example, in a process of forming the second non-display planarization layer 106d and the second planarization layer 106b and a process of forming the anode AN on the second planarization layer 106b, the development process can also proceed, and accordingly, at least one of TMAH and TMA ions can remain in the upper surface of the second non-display planarization layer 106d.

TMAH and TMA ions remaining in the upper surface of the second non-display planarization layer 106d can damage the second non-display planarization layer 106d, and moisture introduced through the damaged portion can cause cracks in the metal line CL provided at the lower end of the second non-display planarization layer 106d.

To prevent this, over-etching can also be performed on the upper surface of the second non-display planarization layer 106.

For example, when the anode AN is etched to form the anode AN on the second planarization layer 106b, etching can be performed on the upper surface of the second planarization layer 106b.

Accordingly, TMAH and TMA ions in the upper surface of the second planarization layer 106b can be removed.

In this case, the entire upper surface of the second non-display planarization layer 106d can be etched.

For example, after the second non-display planarization layer 106d and the second planarization layer 106b are formed, an additional etching process can be performed only on the entire upper surface of the second non-display planarization layer 106d.

Accordingly, the thickness of the second non-display planarization layer 106d can be smaller than the thickness of the second planarization layer 106b.

However, only the second non-display planarization layer 106d provided in the bending area BA can be etched using a mask.

Accordingly, as illustrated in FIG. 11, the thickness D of the second non-display planarization layer 106d provided in the bending area BA can be smaller than the thickness E of the second non-display planarization layer 106d provided in the connection non-display area CNDA and the thickness F of the second non-display planarization layer 106d provided in the pad non-display area PNDA.

In this case, there are no TMAH and TMA ions in the upper surface of the second non-display planarization layer 106d provided in the bending area BA, and TMAH and TMA ions may be present in the upper surface of the second non-display planarization layer 106d provided in the connection non-display area CNDA and the pad non-display area PNDA.

To provide an additional description, the thickness A of the non-display bank NBK provided in the bending area BA can be smaller than the thickness B of the non-display bank NBK provided in the connection non-display area CNDA and the thickness C of the non-display bank NBK provided in the pad non-display area PNDA. In this case, there are no TMAH and TMA ions in the upper surface of the non-display bank NBK provided in the bending area BA, and TMAH and TMA ions may be present in the upper surface of the non-display bank NBK provided in the connection non-display area CNDA and the pad non-display area PNDA.

Also, there may be no TMAH and TMA ions in the entire upper surface of the second non-display planarization layer 106d, and in this case, the thickness of the second non-display planarization layer 106d can be smaller than the thickness of the second planarization layer 106b.

However, as illustrated in FIG. 11, when the thickness D of the second non-display planarization layer 106d provided in the bending area BA is smaller than the thickness E of the second non-display planarization layer 106d provided in the connection non-display area CNDA and the thickness F of the second non-display planarization layer 106d provided in the pad non-display area PNDA, there are no TMAH and TMA ions in the upper surface of the second non-display planarization layer 106d provided in the bending area BA, and TMAH and TMA ions can be present in the upper surface of the second non-display planarization layer 106d provided in the connection non-display area CNDA and the pad non-display area PNDA.

Next, the non-display bank NBK can be covered by a non-display touch passivation layer 108e including an organic material.

As described above with reference to FIGS. 9 and 10, when the non-display bank NBK is covered by the non-display touch passivation layer 108e, penetration of moisture can be blocked by the non-display touch passivation layer 108e. Also, when the non-display bank NBK is covered by the non-display touch passivation layer 108e, because the thickness of the bending area BA increases, the stress applied to the bending area BA can be reduced.

Accordingly, cracks in the metal line CL provided in the bending area BA can be prevented or reduced. Therefore, the quality of a light emitting display apparatus can be improved.

In this case, the non-display touch insulation layer 108d may not be provided between the non-display bank NBK and the non-display touch passivation layer 108e, or as illustrated in FIG. 11, the non-display touch insulation layer 108d can be provided between the non-display bank NBK and the non-display touch passivation layer 108e in the connection non-display area CNDA and the pad non-display area PNDA.

Finally, the non-display touch passivation layer 108e can include the same material as the touch passivation layer 108c covering the touch electrodes TE1 and TE2 provided in the display area DA.

In this case, the non-display touch passivation layer 108e can be formed together with the touch passivation layer 108c.

FIG. 12 is another exemplary diagram illustrating a bending area applied to a light emitting display apparatus according to an embodiment of the present disclosure. In the following descriptions, details that are the same as or similar to details described with reference to FIGS. 1 to 11 will be omitted or briefly described.

First, as described above, the first non-display planarization layer 106c provided on the flexible substrate 101 or the buffer 102, the metal line ML provided on the first non-display planarization layer, the second non-display planarization layer 106d covering the first non-display planarization layer 106c and the metal line ML, and the non-display bank NBK provided on the second non-display planarization layer 106d can be included in the bending area BA.

The thickness A of the non-display bank NBK provided in the bending area BA can be smaller than the thickness B of the non-display bank NBK provided in the connection non-display area CNDA and the thickness C of the non-display bank NBK provided in the pad non-display area PNDA.

In this case, there are no TMAH and TMA ions in the upper surface of the non-display bank NBK provided in the bending area BA, and TMAH and TMA ions can be in the upper surface of the non-display bank NBK provided in the connection non-display area CNDA and the pad non-display area PNDA.

Next, in the connection non-display area CNDA and the pad non-display area PNDA, the non-display bank NBK can be covered by the non-display touch passivation layer 108e including an organic material.

For example, in a light emitting display apparatus according to an embodiment of the present disclosure, as described with reference to FIGS. 9 to 11, the non-display bank NBK provided in the bending area BA can be covered by the non-display touch passivation layer 108e.

However, in a light emitting display apparatus according to an embodiment of the present disclosure, as illustrated in FIG. 12, the non-display bank NBK provided in the bending area BA may not be covered by the non-display touch passivation layer 108e. In this case, the non-display touch passivation layer 108e including an organic material can be provided on the non-display bank NBK in the connection non-display area CNDA and the pad non-display area PNDA.

In this case, the non-display touch insulation layer 108d may not be provided between the non-display bank NBK and the non-display touch passivation layer 108e, or as illustrated in FIG. 12, the non-display touch insulation layer 108d can be provided between the non-display bank NBK and the non-display touch passivation layer 108e in the connection non-display area CNDA and the pad non-display area PNDA.

For example, the non-display touch passivation layer 108e can be formed in the connection non-display area CNDA and the pad non-display area PNDA among the upper ends of the non-display bank NBK.

For example, a touch passivation layer material forming the non-display touch passivation layer 108e can be deposited on all of the connection non-display area CNDA, the pad non-display area PNDA, and the bending area BA.

In this case, the touch passivation layer material provided on the non-display bank NBK in the bending area BA can be removed by a developing process using a photoresist. Accordingly, the non-display bank NBK can be exposed in the bending area BA. A solution containing TMAH can be used in the developing process for the touch passivation layer material. Therefore, TMAH and TMA ions can remain in the upper surface of the non-display bank NBK exposed after the developing process.

Therefore, an additional etching process can be further performed on the exposed non-display bank NBK. Accordingly, TMAH and TMA ions remaining in the upper surface of the exposed non-display bank NBK can be removed.

That is, there are no TMAH and TMA ions in the upper surface of the non-display bank NBK provided in the bending area BA, and TMAH and TMA ions may be in the upper surface of the non-display bank NBK provided in the connection non-display area CNDA and the pad non-display area PNDA.

Furthermore, by the additional etching process as described above, the thickness A of the non-display bank NBK provided in the bending area BA can be smaller than the thickness B of the non-display bank NBK provided in the connection non-display area CNDA and the thickness C of the non-display bank NBK provided in the pad non-display area PNDA.

In this case, before the additional etching process as described above is performed, the etching process for the non-display bank NBK provided in the bending area BA can be performed at least once.

For example, TMAH and TMA ions remaining in the upper surface of the non-display bank NBK can be removed primarily through at least one etching process, and TMAH and TMA ions remaining in the upper surface of the bank NBK after at least one etching process can be removed secondarily through the additional etching process as described above. Accordingly, TMAH and TMA ions can be completely removed from the upper surface of the non-display bank NBK in the bending area BA.

In this case, the second non-display planarization layer 106d provided at the lower end of the non-display bank NBK can be removed by an etching process, so there can be no TMAH and TMA ions in the upper surface of the second non-display planarization layer 106d provided in the bending area BA.

However, the etching process for the second non-display planarization layer 106d provided at the lower end of the non-display bank NBK can be omitted, and in this case, TMAH and TMA ions may be present in the upper surface of the second non-display planarization layer 106d provided in the bending area BA.

Finally, as illustrated in FIG. 12, the non-display touch passivation layer 108e provided on the non-display bank NBK in the connection non-display area CNDA and the pad non-display area PNDA can include the same material as the touch passivation layer 108c covering the touch electrodes TE1 and TE2 provided in the display area DA.

In this case, the non-display touch passivation layer 108e can be formed together with the touch passivation layer 108c.

As described above with reference to FIG. 12, after the touch passivation layer material is deposited, an etching process can be primarily performed in order to expose the non-display bank NBK to form the non-display touch passivation layer 108e.

After the non-display bank NBK is exposed, an additional etching process can be performed on the non-display bank NBK secondarily.

In this case, the upper surface of the non-display touch passivation layer 108e can be etched together with the upper surface of the non-display bank NBK.

Therefore, the thickness of the non-display touch passivation layer 108e can be smaller than the thickness of the touch passivation layer 108c.

For example, when the additional etching process is secondarily performed on the exposed non-display bank NBK, the upper surface of the touch passivation layer 108c may not be etched, and the upper surface of the non-display touch passivation layer 108e can be etched together with the non-display bank NBK.

Accordingly, the thickness of the non-display touch passivation layer 108e can be smaller than the thickness of the touch passivation layer 108c.

Hereinafter, additional features of a light emitting display apparatus according to an embodiment of the present disclosure and the features described above will be briefly described.

As described above, at least one organic layer can be provided at the upper end of the metal line ML, in which cracks are generated, in the bending area BA, and for example, the second non-display planarization layer 106d and the non-display bank NBK can be provided. TMAH and TMA ions can remain in the upper surface of the second non-display planarization layer 106d and the upper surface of the non-display bank NBK by a photoresist process performed on the second non-display planarization layer 106d and the non-display bank NBK or by another photoresist process performed after forming the second non-display planarization layer 106d and the non-display bank NBK. Cracks can occur in the metal line ML by TMAH and TMA ions.

In a light emitting display apparatus according to an embodiment of the present disclosure, the upper surface of the organic material layer in which TMAH or TMA ions remain in the bending area BA can be removed through dry over-etching.

Accordingly, cracks in the metal line ML provided in the bending area BA can be prevented or reduced.

First, as described with reference to FIG. 9, the upper surface of the non-display bank NBK provided in the bending area BA can be removed by over-etching. Accordingly, TMAH and TMA ions cannot remain in the upper surface of the non-display bank NBK provided in the bending area BA.

That is, after the non-display bank NBK where TMAH and TMA ions remain is formed, an additional etching process using dry etching can be performed, and accordingly, TMAH and TMA ions can be removed from the upper surface of the non-display bank NBK.

To provide an additional description, after the non-display bank NBK is formed, the non-display touch insulation layer 108d and the touch electrodes TE1 and TE2 are formed, and a dry etching process is performed in each of the processes of forming the non-display touch insulation layer 108d and the touch electrodes TE1 and TE2. When a dry etching process for forming the non-display touch insulation layer 108d and the touch electrodes TE1 and TE2 is performed, a dry etching process can also be performed on the non-display bank NBK. Accordingly, the upper surface of the non-display bank NBK can be further etched, and TMAH and TMA ions remaining in the upper surface of the non-display bank NBK can be removed.

Therefore, cracks in the metal line ML provided in the bending area BA can be prevented or reduced.

In this case, the non-display touch passivation layer 108e may not be provided on the non-display bank NBK, or the non-display touch passivation layer 108e can be provided as illustrated in FIG. 10.

A bending stress can be reduced by the non-display touch passivation layer 108e, and moisture penetration can be further prevented. Accordingly, cracks in the metal line ML provided in the bending area BA can be further prevented or further reduced.

Next, as described with reference to FIG. 11, not only the upper surface of the non-display bank NBK provided in the bending area BA but also the upper surface of the second non-display planarization layer 106d can be removed by over-etching. Accordingly, TMAH and TMA ions may not remain in the upper surface of the second non-display planarization layer 106d provided in the bending area BA.

That is, after the second non-display planarization layer 106d in which TMAH and TMA ions remain is formed, an additional etching process using dry etching can be performed, and accordingly, TMAH and TMA ions can be removed from the upper surface of the second non-display planarization layer 106d.

Because TMAH and TMA ions can be removed from the upper surface of the non-display bank NBK and the upper surface of the second non-display planarization layer 106d, moisture penetration in the direction of the metal line ML can be prevented, and thus cracks in the metal line ML provided in the bending area BA can be prevented or reduced.

In this case, the non-display touch passivation layer 108e may not be present on the non-display bank NBK, or the non-display touch passivation layer 108e can be provided as illustrated in FIG. 11.

A bending stress can be reduced by the non-display touch passivation layer 108e, and moisture penetration can be further prevented. Accordingly, cracks in the metal line ML provided in the bending area BA can be further prevented or further reduced.

To provide an additional description, the amount of TMAH and TMA ions remaining in the upper surface of the second non-display planarization layer 106d is smaller than the amount of TMAH and TMA ions remaining in the upper surface of the non-display bank NBK, and moisture penetrating into the non-display bank NBK can be transferred to the metal line ML through the second non-display planarization layer 106d.

Therefore, as described with reference to FIG. 9, only the upper surface of the non-display bank NBK can be removed through an additional etching process, and accordingly, only TMAH and TMA ions remaining in the upper surface of the non-display bank NBK can be removed.

However, for more complete moisture penetration prevention, not only the upper surface of the non-display bank NBK but also the upper surface of the second non-display planarization layer 106d can be removed through an additional etching process, and thus, not only TMAH and TMA ions remaining in the upper surface of the non-display bank NBK but also TMAH and TMA ions remaining in the upper surface of the second non-display planarization layer 106d can also be removed.

Also, if another organic material layer other than the non-display bank NBK and the second non-display planarization layer 106d is provided at the upper end of the metal line ML provided in the bending area BA, an etching process can be performed on another organic material layer, thereby removing TMAH and TMA ions from an upper surface of another organic material layer.

To provide an additional description, after an organic material layer (e.g., the second non-display planarization layer 106d and the non-display bank NBK) is formed in the bending area BA, various metal layers and inorganic material layers can be formed in the display area DA. A dry etching process can be performed to form various metal layers and inorganic material layers. Accordingly, when a dry etching process is performed for forming various metal layers and inorganic material layers, an upper surface of the organic material layer provided in the bending area BA can be etched and removed. Accordingly, TMAH and TMA ions remaining in the upper surface of the organic material layer provided in the bending area BA can be removed together with the upper surface of the organic material layer.

Next, as described with reference to FIG. 12, the touch passivation layer material deposited in the bending area BA can be removed to expose the non-display bank NBK, and the exposed upper surface of the non-display bank NBK can be removed by an additional etching process. Accordingly, TMAH and TMA ions remaining in an upper surface of the non-display bank NBK can be removed.

In this case, the non-display touch passivation layer 108e can remain only in the connection non-display area CNDA and the pad non-display area PNDA. Also, because an additional etching process is performed on the non-display touch passivation layer 108e, a thickness of the non-display touch passivation layer 108e can be smaller than a thickness of the touch passivation layer 108c provided in the display area DA.

Finally, in a light emitting display apparatus according to an embodiment of the present disclosure, an upper surface of an organic material layer (e.g., the second non-display planarization layer 106d and the non-display bank NBK) provided in the bending area BA can be additionally removed by a dry etching process. Accordingly, TMAH and TMA ions can be completely removed from the upper surface of the organic material layer.

In this case, an upper surface of the first non-display planarization layer 106c provided at the lower end of the metal line ML in the bending area BA can also be removed through a dry etching process.

When the upper surface of the organic material layer is removed by an additional etching process on the upper surface of the organic material layer provided in the bending area BA, upper surfaces of a metal layer and an inorganic layer provided in the display area DA and the non-display area NDA can also be removed. In consideration of this, thicknesses of the metal layer and the inorganic layer provided in the display area DA and the non-display area NDA can be variously set.

If the non-display bank NBK is not provided on the second non-display planarization layer 106d and the non-display touch insulation layer 108d is provided, an additional etching process for the upper surface of the second non-display planarization layer 106d can necessarily proceed.

Also, if the non-display bank NBK is provided on the second non-display planarization layer 106d, another organic layer is provided on the non-display bank NBK, and the non-display touch insulation layer 108d is provided on another organic layer, an additional etching process for the upper surface of another organic layer can necessarily proceed.

A thickness of the non-display touch passivation layer 108e covering the non-display bank NBK in the bending area BA can be variously set in consideration of the neutral plane effect.

The over-etching process for the organic material layer provided in the bending area BA can be any one of etching processes performed after forming the organic material layers 106a, 106b, and NBK. Etching processes performed after the formation of the organic material layers can be performed to form a metal layer and an inorganic layer provided in the display area DA or the non-display area NDA.

When the non-display bank NBK in the bending area BA is not covered by the non-display touch passivation layer 108e, a stress reduction effect in the bending area BA cannot be expected, but TMAH and TMA ions can be removed from the non-display bank NBK, which is most vulnerable to moisture permeation and stress. Therefore, cracks in the metal line ML can be effectively prevented.

The upper surface of the organic material layer from which TMAH and TMA ions are removed through over etching can be formed in a form of a taper or an inverse taper.

In a light emitting display apparatus according to an embodiment of the present disclosure, the upper surface of the organic material layer is recessed by dry etching, and thus TMAH and TMA ions causing cracks can be removed from the upper surface of the organic material layer.

An upper surface of at least one organic material layer among the organic material layers provided in the bending area BA can be removed by an etching process, and in particular, an upper surface of an organic material layer exposed to the outside or an upper surface of an organic material layer covered by the non-display touch passivation layer 108e can be removed by an etching process.

The non-display touch passivation layer 108e may not be provided in the bending area BA to prevent moisture penetration, or can be provided in the bending area BA for a neutral plane effect.

The features of the light emitting display apparatus according to one or more embodiments of the present disclosure are briefly summarized as follows.

A light emitting display apparatus according to one or more embodiments of the present disclosure includes a flexible substrate divided into a display area and a non-display area surrounding the display area; a pixel driving circuit layer provided in the display area and provided with pixel driving circuits; a first planarization layer covering the pixel driving circuit layer in the display area; a second planarization layer covering the first planarization layer; a first non-display planarization layer provided in the non-display area; a metal line provided on the first non-display planarization layer; a second non-display planarization layer covering the first non-display planarization layer and the metal line; and a non-display bank provided on the second non-display planarization layer, wherein the non-display area includes a bending area to be bent, a connection non-display area provided on one side of the bending area and connected to the display area, and a pad non-display area provided on the other side of the bending area, and a thickness of the non-display bank provided in the bending area is smaller than a thickness of the non-display bank provided in the connection non-display area and the pad non-display area.

In one or more embodiments, the metal line is connected to a touch electrode provided on the pixel driving circuit layer, or a transistor or line provided in the pixel driving circuit layer.

In one or more embodiments, the light emitting display apparatus further includes light emitting devices provided on the second planarization layer; an encapsulation layer covering the light emitting devices; and a touch electrode unit provided on the encapsulation layer, wherein the metal line is connected to a touch electrode provided in the touch electrode unit.

In one or more embodiments, the touch electrode unit includes: a first touch insulation layer provided on the encapsulation layer; a bridge electrode provided on the first touch insulation layer; a second touch insulation layer covering the bridge electrode; a touch electrode provided on the second touch insulation layer; and a touch passivation layer covering the second touch insulation layer and the touch electrode, wherein a contact hole is provided in the second touch insulation layer extending to the connection non-display area, and a touch electrode line connected to the touch electrode is connected to the metal line through the contact hole.

In one or more embodiments, the non-display bank is covered by a non-display touch passivation layer including the same material as the touch passivation layer.

In one or more embodiments, the light emitting display apparatus further includes a connection line provided on the flexible substrate; and a buffer provided between the flexible substrate and the pixel driving circuit layer and covering the connection line, wherein the connection line is connected to a transistor or a line provided in the pixel driving circuit layer, and the metal line is connected to the connection line through a contact hole provided in the buffer.

In one or more embodiments, a non-display touch insulation layer provided on the non-display bank and covered by the non-display touch passivation layer is provided in the connection non-display area and the pad non-display area, and the non-display touch insulation layer includes at least one of the same material as the first touch insulation layer and the same material as the second touch insulation layer.

In one or more embodiments, tetramethyl ammonium hydroxide (TMAH) and TMA ions do not remain in an upper surface of the non-display bank provided in the bending area. In other words, an upper surface of the non-display bank provided in the bending area may be free from tetramethyl ammonium hydroxide and ions.

In one or more embodiments, the light emitting display apparatus further includes anodes provided on the second planarization layer; a bank covering outer edges of the anodes; a light emitting layer provided on the anodes; a cathode covering the light emitting layer; and an encapsulation layer covering the cathode, wherein the non-display bank includes the same material as the bank.

In one or more embodiments, the first non-display planarization layer includes the same material as the first planarization layer, and the second non-display planarization layer includes the same material as the second planarization layer.

In one or more embodiments, a thickness of the second non-display planarization layer provided in the bending area is smaller than a thickness of the second non-display planarization layer provided in the connection non-display area and the pad non-display area.

In one or more embodiments, the non-display bank is covered by a non-display touch passivation layer including an organic material.

In one or more embodiments, the non-display touch passivation layer includes the same material as a touch passivation layer covering a touch electrode provided in the display area.

In one or more embodiments, in the connection non-display area and the pad non-display area, the non-display bank is covered by a non-display touch passivation layer including an organic material.

In one or more embodiments, the light emitting display apparatus further includes at least one non-display touch insulation layer provided between the non-display bank and the non-display touch passivation layer in the connection non-display area and the pad non-display area.

In one or more embodiments, the non-display touch passivation layer includes the same material as a touch passivation layer covering a touch electrode provided in the display area.

In one or more embodiments, a thickness of the non-display bank is smaller than a thickness of the bank.

In one or more embodiments, a thickness of the second non-display planarization layer is smaller than a thickness of the second planarization layer.

A light emitting display apparatus according to one or more embodiments of the present disclosure includes a flexible substrate divided into a display area and a non-display area surrounding the display area; a first non-display planarization layer provided in the non-display area; a metal line provided on the first non-display planarization layer; an organic material layer provided on the metal line, wherein the non-display area includes a bending area to be bent, a connection non-display area provided on one side of the bending area and connected to the display area, and a pad non-display area provided on the other side of the bending area, and a thickness of the organic material layer provided in the bending area is smaller than a thickness of the organic material layer provided in the connection non-display area and the pad non-display area.

In a light emitting display apparatus according to at least one embodiment of the present disclosure, at least one of insulation layers provided in the bending area is over-etched. Accordingly, when the insulation layer is formed, TMAH or TMA+ remaining in an upper surface of the insulation layer can be removed by over-etching.

TMAH or TMA+ remaining in an upper surface of the insulation layer can cause cracks in a metal line provided in the bending area.

According to a light emitting display apparatus according to at least one embodiment of the present disclosure, at least one of insulation layers covering a metal line provided in the bending area can be over-etched, and accordingly, TMAH and TMA+ causing cracks in the metal line can be removed.

Accordingly, in a light emitting display apparatus according to at least one embodiment of the present disclosure, cracks may not occur in a metal line provided in the bending area of the light emitting display panel, or the amount of cracks occurring in the metal line can be reduced.

Accordingly, the quality of a light emitting display apparatus can be improved.

The light emitting display apparatus according to one or more embodiments of the present disclosure can be applied to all electronic devices including a light emitting display panel. For example, the light emitting display apparatus according to one or more embodiments of the present disclosure can be applied to a virtual reality (VR) device, an augmented reality (AR) device, a mobile device, a video phone, a smart watch, a watch phone, or a wearable device, foldable device, rollable device, bendable device, flexible device, curved device, electronic notebook, e-book, PMP (portable multimedia player), PDA (personal digital assistant), MP3 player, mobile medical device, desktop PC, laptop PC, netbook computer, workstation, navigation, car navigation, vehicle display devices, televisions, wall paper display devices, signage devices, game devices, laptops, monitors, cameras, camcorders, and home appliances.

The above-described feature, structure, and effect of the present disclosure are included in at least one embodiment of the present disclosure, but are not limited to only one embodiment. Furthermore, the feature, structure, and effect described in at least one embodiment of the present disclosure can be implemented through combination or modification of other embodiments by those skilled in the art. Therefore, content associated with the combination and modification should be construed as being within the scope of the present disclosure.

It will be apparent to those skilled in the art that various modifications and variations can be made in the present disclosure without departing from the scope of the disclosure. Thus, it is intended that the present disclosure covers the modifications and variations of this disclosure provided they come within the scope of the present disclosure.

## Claims

1. A light emitting display apparatus comprising:
a flexible substrate (101) divided into a display area (DA) and a non-display area (NDA) surrounding the display area (DA);
a pixel driving circuit layer (PDCL) provided in the display area (DA) and provided with pixel driving circuits;
a first planarization layer (106a) covering the pixel driving circuit layer (PDCL) in the display area (DA);
a second planarization layer (106b) covering the first planarization layer (106a);
a first non-display planarization layer (106c) provided in the non-display area (NDA);
a metal line (ML) provided on the first non-display planarization layer (106c);
a second non-display planarization layer (106d) covering the first non-display planarization layer (106c) and the metal line (ML); and
a non-display bank (NBK) provided on the second non-display planarization layer (106d),
wherein the non-display area (NDA) includes a bending area (BA) to be bent, a connection non-display area (CNDA) provided on one side of the bending area (BA) and connected to the display area (DA), and a pad non-display area (PNDA) provided on the other side of the bending area (BA), and
a thickness (A) of the non-display bank (NBK) provided in the bending area (BA) is smaller than a thickness (B, C) of the non-display bank (NBK) provided in the connection non-display area (CNDA) and the pad non-display area (PNDA).

2. The light emitting display apparatus of claim 1, wherein the metal line (ML) is connected to a touch electrode (TE1, TE2) provided on the pixel driving circuit layer (PDCL), or a transistor (Tsw1) or line provided in the pixel driving circuit layer (PDCL).

3. The light emitting display apparatus of claim 1, further comprising:
light emitting devices (ED) provided on the second planarization layer (106b);
an encapsulation layer (107) covering the light emitting devices (ED); and
a touch electrode unit (100b) provided on the encapsulation layer (107),
wherein the metal line (ML) is connected to a touch electrode (TE1, TE2) provided in the touch electrode unit (100b).

4. The light emitting display apparatus of claim 3, wherein the touch electrode unit (100b) includes:
a first touch insulation layer (108a) provided on the encapsulation layer (107);
a bridge electrode (BR) provided on the first touch insulation layer (108a);
a second touch insulation layer (108b) covering the bridge electrode (BR);
a touch electrode (TE1, TE2) provided on the second touch insulation layer (108b); and
a touch passivation layer (108c) covering the second touch insulation layer (108b) and the touch electrode (TE1, TE2),
wherein a contact hole (CH1) is provided in the second touch insulation layer (108b) extending to the connection non-display area (CNDA), and
a touch electrode line (TEL) connected to the touch electrode (TE1, TE2) is connected to the metal line (ML) through the contact hole (CH1).

5. The light emitting display apparatus of claim 4, wherein the non-display bank (NBK) is covered by a non-display touch passivation layer (108e) including the same material as the touch passivation layer (108c).

6. The light emitting display apparatus of claim 1, further comprising:
a connection line (CL) provided on the flexible substrate (101); and
a buffer (102) provided between the flexible substrate (101) and the pixel driving circuit layer (PDCL) and covering the connection line (CL),
wherein the connection line (CL) is connected to a transistor (Tsw1) or a line provided in the pixel driving circuit layer (PDCL), and
the metal line (ML) is connected to the connection line (CL) through a contact hole (CH2) provided in the buffer (102).

7. The light emitting display apparatus of claim 5, wherein a non-display touch insulation layer (108d) provided on the non-display bank (NBK) and covered by the non-display touch passivation layer (108e) is provided in the connection non-display area (CNDA) and the pad non-display area (PNDA), and
the non-display touch insulation layer (108d) includes at least one of the same material as the first touch insulation layer (108a) and the same material as the second touch insulation layer (108b).

8. The light emitting display apparatus of any of claims 1 to 7, wherein an upper surface of the non-display bank (NBK) provided in the bending area (BA) is free from tetramethyl ammonium hydroxide (TMAH) and TMA ions.

9. The light emitting display apparatus of any of claims 1 to 8, further comprising:
anodes (AN) provided on the second planarization layer (106b);
a bank (BK) covering outer edges of the anodes (AN);
a light emitting layer (EL) provided on the anodes (AN);
a cathode (CA) covering the light emitting layer (EL); and
an encapsulation layer (107) covering the cathode (CA),
wherein the non-display bank (NBK) includes the same material as the bank (BK),
wherein, preferably, a thickness of the non-display bank (NBK) is smaller than a thickness of the bank (BK).

10. The light emitting display apparatus of any of claims 1 to 9, wherein the first non-display planarization layer (106c) includes the same material as the first planarization layer (106a), and
the second non-display planarization layer (106d) includes the same material as the second planarization layer (106b),
wherein, preferably, a thickness of the second non-display planarization layer (106d) is smaller than a thickness of the second planarization layer (106b).

11. The light emitting display apparatus of claim 1, wherein a thickness (D) of the second non-display planarization layer (106d) provided in the bending area (BA) is smaller than a thickness (E) of the second non-display planarization layer (106d) provided in the connection non-display area (CNDA) and the pad non-display area (PNDA).

12. The light emitting display apparatus of claim 11, wherein the non-display bank (NBK) is covered by a non-display touch passivation layer (108e) including an organic material.

13. The light emitting display apparatus of claim 12, wherein the non-display touch passivation layer (108e) includes the same material as a touch passivation layer (108c) covering a touch electrode (TE1, TE2) provided in the display area (DA).

14. The light emitting display apparatus of claim 1, wherein in the connection non-display area (CNDA) and the pad non-display area (PNDA), the non-display bank (NBK) is covered by a non-display touch passivation layer (108e) including an organic material, and
preferably, the light emitting display apparatus further comprises:
at least one non-display touch insulation layer (108d) provided between the non-display bank (NBK) and the non-display touch passivation layer (108e) in the connection non-display area (CNDA) and the pad non-display area (PNDA).

15. The light emitting display apparatus of claim 14, wherein the non-display touch passivation layer (108e) includes the same material as a touch passivation layer (108c) covering a touch electrode (TE1, TE2) provided in the display area (DA).
